# EUROPÄISCHE PATENTSCHRIFT

(11) **EP 0 519 268 B1**
(45) Veröffentlichungstag und Bekanntmachung des Hinweises auf die Patenterteilung: **20.03.1996**
(21) Anmeldenummer: 92109343.1
(22) Anmeldetag: 03.06.1992
(51) Int. Cl.: H01L 29/06, H01L 29/732, H01L 21/762

(54) **Hochspannungstransistor**
High-voltage transistor
Transistor à haute tension

(30) Priorität: 17.06.1991 DE 4119904
(43) Veröffentlichungstag der Anmeldung: 23.12.1992
(73) Patentinhaber: TEMIC TELEFUNKEN microelectronic GmbH, D-74072 Heilbronn (DE)
(72) Erfinder: Broström, Doris, W-7100 Heilbronn (DE); Harmel, Hartmut, W-3520 Hofgeismar (DE); Jehl, Bernhard, Dr., W-7056 Weinstadt (DE); Ryman, Lennart, W-7100 Heilbronn (DE); Viehmann, Kurt-Rainer, W-7102 Lehrensteinsfeld (DE)
(74) Vertreter: Maute, Hans-Jürgen, Dipl.-Ing.

(56) Entgegenhaltungen:
- EP-A- 0 018 730
- FR-A- 2 132 347
- FR-A- 2 305 854
- FR-A- 2 518 815
- GB-A- 2 029 096
- GB-A- 2 069 235
- US-A- 4 047 217
- US-A- 4 215 358
- Patent Abstracts of Japan, vol. 8, no. 13 (E-222) January 20, 1984 & JP-A-58-176 978

## Beschreibung

Die Erfindung betrifft einen bipolaren npn-Planartransistor mit einem mehrere Halbleiterbereiche mit unterschiedlichen Leitfähigkeitstypen aufweisenden Halbleiterkörper gemäß dem Oberbegriff des Patentanspruches 1.

Es ist bekannt, daß die Betriebsweise von Halbleiterbauelementen und besonders von Transistoren häufiger von Oberflächeneffekten als von Effekten, die sich im Innern des Halbleiterkörpers abspielen, schädlich beeinflußt werden. Bei einem npn-Planartransistor grenzen beispielsweise alle Zonen an eine Oberfläche des Halbleiterkörpers, dessen Oberfläche daher zum Schutz gegen Oberflächeneffekte mit Isolierschichten überzogen ist. Bei solchen Transistoren bildet sich im oberflächennahen Bereich der Kollektorzone eine Anreicherungsschicht (Akkumulationsschicht) aus, die zur Einschnürung der Raumladungszone führen kann. Dieser Effekt beruht auf positiven Ladungen in den Isolierschichten.

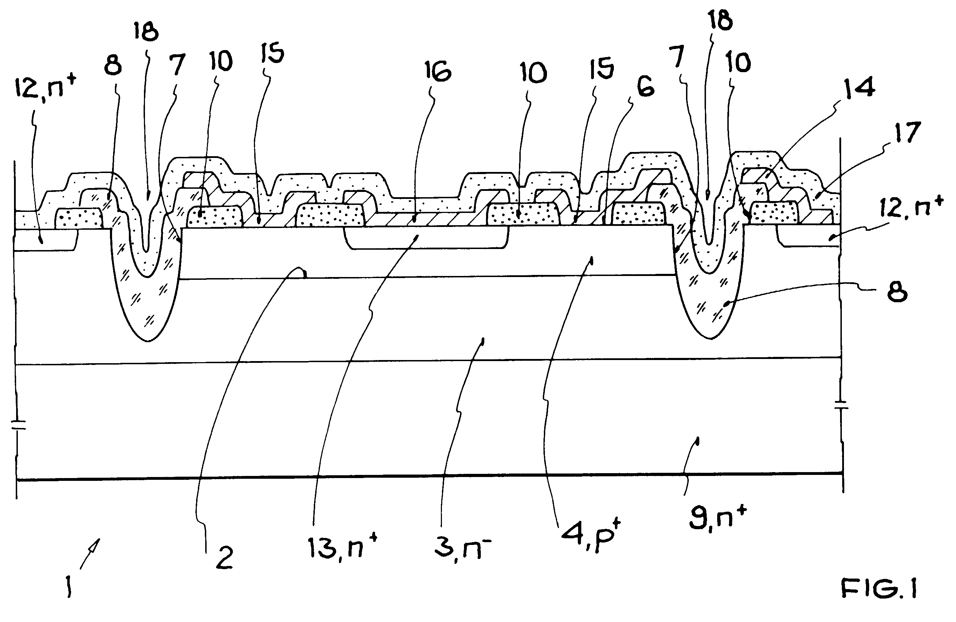

zur Vermeidung derartiger oberflächennahen Anreicherungsschichten ist es weiterhin bekannt, freiliegende pn-Übergänge bei Thyristoren, Transistoren oder Dioden mit Glasschichten zu belegen. Hierbei werden in dem Halbleiterkörper vertikal ausgerichtete, ringförmige Einschnitte, sogenannte Mesa-Gräben vorgesehen, welche von der Oberfläche bis in eine Tiefe verlaufen, die tiefer als der pn-Übergang sind. In diese Mesa-Gräben wird eine Glaspaste elektrophoretisch abgeschieden und an Ort und Stelle verfestigt und gebrannt. Diese Glaspassivierung hat die Eigenschaft, daß negative Ladungen am pn-Übergang entlang der Oberfläche erzeugt werden, so daß eine Oberflächenakkumulation nicht mehr auftreten kann. Eine solche als Hochspannungs-npn-Transistor ausgebildete Halbleiteranordnung zeigt die Figur 1 in einer schematischen Querschnittsansicht, deren Aufbau nachfolgend beschrieben wird. Ein derartiger Transistor ist beispielsweise aus der FR-A-2 518 815 bekannt.

Die Halbleiteranordnung 1 nach Figur stellt einen Hochvolt-npn-Bipolartransistor dar, der in einer Glas-Mesa-Graben-Technik hergestellt ist. Dieser Mesa-Transistor 1 ist auf einer n⁺-leitenden Substratschicht 9 aufgebaut. Auf diesem Substrat 9 ist eine als Kollektor dienende n⁻-leitende Epitaxieschicht 3 aufgewachsen. Eine p⁺-leitende Basisschicht 4 wird mittels Diffusion, beispielsweise mit Bor in der Epitaxieschicht 3 hergestellt, anschließend wird eine n⁺-leitende Emitterzone 13 in diese Basisschicht 4 diffundiert. Gleichzeitig mit der Eindiffundierung der Emitterzone 13 werden auch n⁺-leitende Kollektorkontaktzonen 12 hergestellt.

Nach diesem Diffusionsvorgang erfolgt das Ätzen des Mesa-Grabens 18, der die Basiszone 4 vollständig umschließt und sich von der Oberfläche 6 bis in die Kollektorschicht 3 erstreckt. Zur Herstellung des Mesa-Grabens 18 wird eine zuvor auf die Oberfläche 6 des Halbleiterkörpers 1 aufgebrachte Oxidschicht freigeätzt. Nun wird dieser Mesa-Graben 18 mittels Elektrophorese mit einer Glasschicht 8 aufgefüllt und anschließend einem Brennprozeß von ca. 800 °C unterzogen.

Nach Öffnung der Oxidschicht 10 zur Kontaktierung der Kollektorkontaktzone 12, der Basiszone 4 und der Emitterzone 13 wird eine Aluminiumschicht abgeschieden, und anschließend derart strukturiert, daß eine Leitbahn 14 die Kollektorkontaktzone 12, eine Leitbahn 15 zur Kontaktierung der Basiszone 4 und eine Leitbahn 16 zur Kontaktierung der Emitterzone 13 entsteht. Zum Schutz der gesamten Halbleiteroberfläche kann noch eine zusätzliche dicke Nitridschicht (SiₓN_{y}) 17 abgeschieden werden.

Diese bekannte Anordnung nach Figur 1 weist jedoch den Nachteil auf, daß die Glaspassivierung ab 150 °C in bezug auf die Negativität der Ladungsträger nicht mehr stabil ist. Dies kann durch C/U-Messungen an Glasschichten bei erhöhter Temperatur gemessen werden. Diese Instabilität führt dann zu Sperrspannungsverlusten an den pn-Übergängen solcher Halbleiterbauelemente. Insbesondere konnte festgestellt werden, daß bei Durchführung von Tests, z. B. HTRB-Test (high temperature reverse bias test) sowie bei thermischer Lagerung bei erhöhter Temperatur, eine negative Drift der Durchbruchspannung (U_{(BR)CES}) auftritt.

Aus Patent Abstracts of Japan, Band 8, Nr. 13 (E-222), 20. Januar 1984 und JP-A-58-176 978 ist eine Germanium-Avalanche-Fotodiode bekannt, bei der eine in das n-dotierte Germanium-Substrat eingebettete p-dotierte Zone von einem schwach p-dotierten Guard-Ring umgeben ist. Der Guard-Ring dringt tiefer in das Substrat ein als die eingebettete p-dotierte Zone, die mit dem Substrat den pn-Übergang der Fotodiode bildet. Auf der Oberfläche ist der Guard-Ring und insbesondere die Grenze zwischen Guard-Ring und dem Germanium-Substrat durch einen SiO₂-Film passiviert. Mit dieser Anordnung wird eine Reduzierung des Dunkelstroms der Fotodiode erreicht.

Die Aufgabe der Erfindung besteht daher darin, einen bipolaren npn-Planartransistor der eingangs genannten Art derart zu schaffen, daß eine Temperaturstabilität bis über 200 °C hinaus erreicht wird.

Die Lösung dieser Aufgabe ist durch die kennzeichnenden Merkmale des Patentanspruches 1 gelöst.

Das Wesen der Erfindung besteht also darin, eine schwach dotierte p-Zone ringförmig um die Basiszone zu legen, die von der Oberfläche des Halbleiterkörpers ausgehend bis in eine solche Tiefe reicht, die größer als die Tiefe der Basiszone ist, also insbesondere tiefer als der pn-Übergang reicht. Durch diese erfindungsgemäße Maßnahme wird der Störstellengradient des pn-Überganges abgesenkt und die Sperrspannungsaufnahme mehr als vorher in die schwach dotierte p-Zone verlagert.

Mit einem solchen Planartransistor können hohe Sperrspannungen unabhängig von den in der Glaspassivierung vorhandenen Oberflächenladungen erreicht werden, so daß eine Temperaturstabilität bis über 200 °C erreicht wird. Die Dimensionierung sowie die Dotierung der Basiszone und dieser erfindungsgemäßen p-Zone hängen von der geforderten Sperrspannung ab. Schließlich wird auch eine Verbesserung des dynamischen Schaltverhaltens sowie eine höhere Grenzfrequenz gegenüber herkömmlichen Transistoren mit durchgehend tiefer Bor-Aluminium-Diffusion als Basis in einer ganzflächigen Ausführung erzielt.

Bei einer besonders vorteilhaften Weiterbildung der Erfindung wird eine weitere Erhöhung der temperaturstabilen Sperrspannung dadurch erreicht, daß ein direkt an die p-Zone sich anschließender zusätzlicher ringförmig umschließender Mesa-Graben vorgesehen ist, wobei sich dieser Mesa-Graben tiefer in den Halbleiterkörper erstreckt als die p-Zone. Die die p-Zone abdeckende Passivierungsschicht bedeckt auch die Oberfläche dieses Mesa-Grabens.

Vorzugsweise besteht diese Passivierungsschicht aus Glas oder aus einer mittels CVD-Abscheidung gewonnenen Isolierschicht. Eine solche Isolierschicht kann gemäß einer weiteren Ausführungsform der Erfindung aus einer oder mehreren SIPOS-Schichten (semiisolierendes Polysilizium) und einer zusätzlichen SiₓN_{y}-Schicht (Siliziumnitrid) aufgebaut sein.

Die erfindungsgemäße Halbleiteranordnung kann mit Vorteil zum Aufbau eines npn-Bipolartransistors verwendet werden, wobei der pn-Übergang die Kollektor-Basis-Diode darstellt.

Schließlich kann zur Herstellung des erfindungsgemäßen Halbleiters die p-Zone durch Ionenimplantation mit nachfolgender Diffusion erzeugt werden.

Im folgenden soll die Erfindung anhand von Ausführungsbeispielen im Zusammenhang mit den Zeichnungen dargestellt und erläutert werden. Es zeigen:
- Figur 2: eine schematische Querschnittsansicht eines ersten Ausführungsbeispiels der erfindungsgemäßen Halbleiteranordnung mit einem Mesa-Graben,
- Figur 3: eine schematische Querschnittsdarstellung eines zweiten Ausführungsbeispiels der erfindungsgemäßen Halbleiteranordnung ohne Mesa-Graben und
- Figur 4: eine schematische Querschnittsdarstellung einer Variante des Ausführungsbeispieles nach Figur 3.

In den Figuren werden Halbleiterbereiche und Elemente einander entsprechender Funktionen mit den gleichen Bezugszeichen versehen.

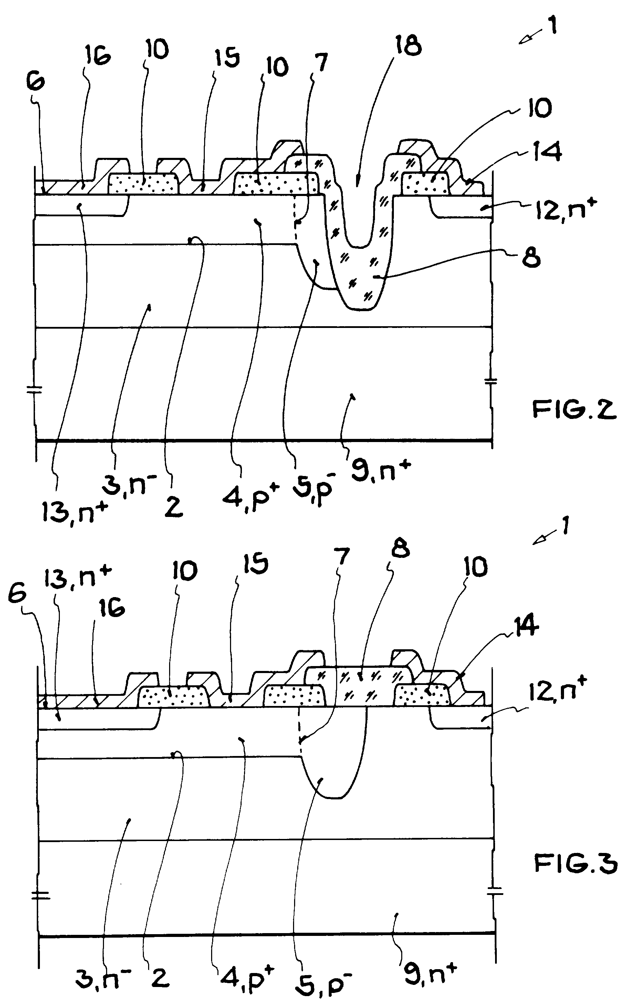

In Figur 2 ist ein Halbleiterkörper 1 mit einem n⁺-leitenden Substrat 9 gezeigt. Auf diesem Substrat 9 ist ein epitaktisch erzeugter n⁻-leitender Halbleiterbereich 3 angeordnet, der die Funktion eines Kollektors aufweist. Zur Bildung eines pn-Überganges 2 ist in diesen Halbleiterbereich 3 ein p⁺-leiten- der Halbleiterbereich 4 eindiffundiert, in dessen Oberfläche 6 eine weitere, n⁺-leitende Zone 13 eindiffundiert ist. Die Halbleiterzone 4 bildet eine Basis, während die Zone 13 als Emitter dient. Weiterhin ist in die Kollektorzone 3 eine n⁺-leitende Kollektorkontaktzone 12 eindiffundiert. Somit stellt die Halbleiteranordnung nach Figur 2 einen npn-Bipolartransistor dar.

Die äußere Begrenzungsfläche des Halbleiterbereiches 4 ist mit dem Bezugszeichen 7 versehen. An diese Grenzfläche 7 schließt sich direkt die erfindungsgemäße, schwach leitende p⁻-leitende Zone an, die sich von der Oberfläche 6 des Halbleiterkörpers 1 bis in eine Tiefe erstreckt, die tiefer als der Halbleiterbereich 4 bzw. der pn-Übergang 2 ist.

An diese p⁻-Zone 5 schließt sich direkt ein Mesa-Graben 18 an, der sich ebenfalls von der Oberfläche 6 aus mit einer größeren Tiefe als die p⁻-Zone 5 in den Halbleiterbereich 3 erstreckt. Eine auf die Oberfläche 6 aufgebrachte Oxidschicht 10 diente zur Erzeugung des Mesa-Grabens 18, einer Kontaktöffnung für die Basiszone 4, einer Kontaktöffnung für die Emitterzone 13 sowie einer Kontaktöffnung für die Kollektorkontaktzone 12. Die Oberfläche des Mesa-Grabens 18 sowie dessen Ränder werden mit einer Passivierungsschicht 8 versehen, so daß die mit Aluminium dotierte p⁻-leitende Zone 5 ebenfalls bedeckt ist. Eine auf die Oberfläche aufgebrachte Aluminiumschicht dient nach deren Strukturierung als Kontaktschicht 14 für die Kollektorkontaktzone 12, als Kontaktschicht 15 für die Basiszone 4 und als Kontaktschicht 16 für die Emitterzone 13.

Die bei diesem Ausführungsbeispiel nach Figur 2 mittels Ionenimplantation und anschließender Diffusion erzeugte p⁻-Zone 5 reicht in eine Tiefe von etwa 55 bis 60 µm.

Das Ausführungsbeispiel nach Figur3 unterscheidet sich von demjenigen nach Figur 2 dadurch, daß kein Mesa-Graben vorgesehen ist. Die erfindungsgemäße p⁻-leitende Zone 5 schließt sich direkt an den p⁺-leitenden Halbleiterbereich 4 an, und umschließt diese Basiszone 4 vollständig. Im Bereich dieser p⁻-Zone 5 ist die Oberfläche 6 nicht mit einer Oxidschicht 10 versehen. Dort befindet sich eine Passivierungsschicht 8 aus Glas.

Der Vorteil dieser Ausführungsform der Erfindung gegenüber derjenigen nach Figur 2 besteht darin, daß der Halbleiterkörper eine größere mechanische Stabilität aufweist, da er keinen Mesa-Graben aufweist.

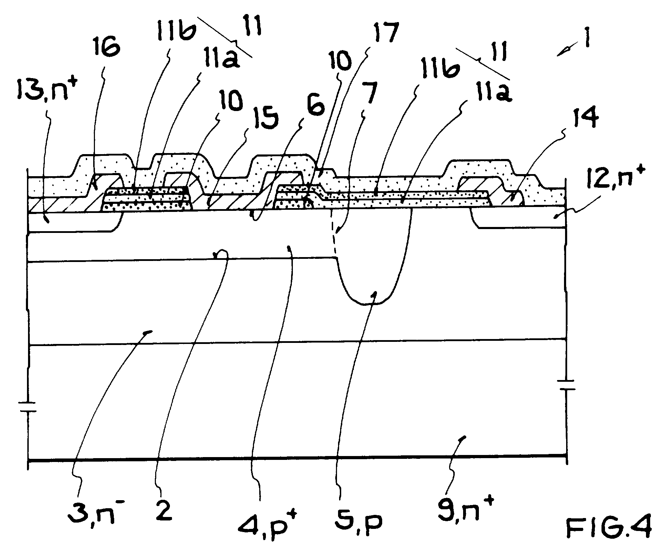

Schließlich entspricht das Ausführungsbeispiel der Figur 4 demjenigen nach Figur 3, wobei anstatt der Glaspassivierung 8 Isolationsschichten 11 vorgesehen sind. Dieses Ausführungsbeispiel stellt eine Planarversion mit der erfindungsgemäßen p-Zone 5 dar. Hierbei ist diese p-Zone 5 mit einer Isolationsschichtfolge aus Schichten 11a und 11b abgedeckt. Die erste Schicht 11a ist eine sauerstoffdotierte SIPOS-Schicht. Die Emitterzone 13 und Basisschicht 4 wird von einer ähnlich aufgebauten Isolationsschichtfolge aus Schichten 11a und 11b abgedeckt, wobei jedoch die ursprünglich aufgewachsene Oxidschicht 10 nicht entfernt wurde, so daß die O-SIPOS-Schicht 11a als auch die N-SIPOS-Schicht 11b auf diese Oxidschicht 10 abgeschieden werden. Schließlich wird eine die gesamte Oberfläche abdeckende letzte Schicht 17 aus Nitrid (SiₓN_{y}) abgeschieden. Der Vorteil einer solchen Anordnung gemäß Figur 4 besteht darin, daß die Bauelemente im Layout feiner strukturierbar sind und peripher verschaltete Bauteile entworfen werden können.

Die zuvor anhand den Ausführungsbeispielen beschriebene Erfindung ist nicht nur auf Bipolartransistoren, sondern auch auf Thyristoren und Dioden anwendbar.

## Patentansprüche

1. Bipolarer npn-Planartransistor mit einem mehrere Halbleiterbereiche mit unterschiedlichen Leitfähigkeitstypen aufweisenden Halbleiterkörper (1), welche mindestens einen pn-Übergang (2) mittels einem n-leitenden Halbleiterbereich (3) und einem p-leitenden Halbleiterbereich (4) bilden, wobei der n-leitende Halbleiterbereich (3) unter dem in seiner Ausdehnung begrenzten p-leitenden Halbleiterbereich (4) liegt und diesen vollständig umschließt, dadurch gekennzeichnet,
- daß entlang der die flächenhafte Ausdehnung begrenzenden Grenzfläche (7) des p-leitenden Halbleiterbereiches (4) eine von der Oberfläche (6) des Halbleiterkörpers (1) sich erstreckende p-Zone (5) vorgesehen ist, die diesen p-leitenden Halbleiterbereich (4) vollständig umschließt,
- daß sich diese p-Zone (5) tiefer in den Halbleiterkörper (1) erstreckt als der p-leitende Halbleiterbereich (4),
- daß die Breite dieser p-Zone (5) gering ist im Vergleich zur Ausdehnung des p-leitenden Halbleiterbereiches (4),
- daß diese p-Zone (5) schwach p-dotiert ist und dabei schwächer dotiert ist als der p-leitende Halbleiter bereich (4) und
- daß diese p-Zone (5) vollständig mit einer Passivierungsschicht (8) abgedeckt ist.

2. Bipolarer npn-Planartransistor nach Anspruch 1, dadurch gekennzeichnet, daß ein direkt an die p-Zone (5) sich anschließender, diese p-Zone (5) ringförmig umschließender Mesa-Graben (18) vorgesehen ist, daß sich dieser Mesa-Graben (18) tiefer in den Halbleiterkörper (1) erstreckt als die p-Zone (5) und daß die Oberfläche des Mesa-Grabens (18) mit der Passivierungsschicht (8) abgedeckt ist.

3. Bipolarer npn-Planartransistor nach Anspruch 1 oder 2, dadurch gekennzeichnet, daß die Passivierungsschicht (8) aus Glas besteht.

4. Bipolarer npn-Planartransistor nach Anspruch 1 oder 2, dadurch gekennzeichnet, daß die Isolierschicht (11) aus einer oder mehreren SIPOS-Schichten (semiisolierendes polykristallines Silizium) (11a, 11b) aufgebaut ist, die von einer Nitridschicht (SiₓN_{y}) (17) abgedeckt ist.

5. Bipolarer npn-Planartransistor nach einem der Ansprüche 1 bis 4, dadurch gekennzeichnet, daß der genannte pn-Übergang (2) die Kollektor-Basis-Diode des Transistors darstellt.

6. Verfahren zur Herstellung des bipolaren npn-Planartransistors nach einem der vorhergehenden Ansprüche, dadurch gekennzeichnet, daß die p-Zone (5) durch Ionenimplantation mit nachfolgender Diffusion erzeugt wird.

7. Verfahren nach Anspruch 7, dadurch gekennzeichnet, daß die p-Zone (5) durch Ionenimplantation von Aluminium erzeugt wird.

## Claims

1. A bipolar npn- planar transistor with a semiconductor body (1) comprising a plurality of semiconductor zones with different conductivity types, which semiconductor zones form at least one pn-junction (2) by means of a n-conducting semiconductor zone (3) and a p-conducting semiconductor zone (4), where the n-conducting semiconductor zone (3) lies below the p-conducting semiconductor zone (4) which is limited in its expanse and completely surrounds the latter, characterised in that
- along the boundary surface (7) of the p-conducting semiconductor zone (4), which boundary zone delimits the surface expanse, a p-zone (5) is provided which extends from the surface (6) of the semiconductor body (1) and completely surrounds this p-conducting semiconductor zone (4),
- this p-zone (5) extends deeper into the semiconductor body (1) than the p-conducting semiconductor zone (4),
- the breadth of this p-zone (5) is small in comparison to the expanse of the p-conducting semiconductor zone (4),
- this p-zone (5) is weakly p-doped and is more weakly doped than the p-conducting semiconductor zone (4) and
- this p-zone (5) is completely covered by a passivation layer (8).

2. A bipolar npn- planar transistor as claimed in Claim 1, characterised in that a mesa trench (18) is provided which directly adjoins the p-zone (5) and surrounds this p-zone (5) in an annular fashion, that this mesa trench (18) extends deeper into the semiconductor body (1) than the p-zone (5), and that the surface of the mesa trench (18) is covered by the passivation layer (8).

3. A bipolar npn- planar transistor as claimed in Claim 1 or 2, characterised in that the passivation layer (8) is composed of glass.

4. A bipolar npn- planar transistor as claimed in Claim 1 or 2, characterised in that the insulating layer (11) is constructed from one or several SIPOS layers (semiinsulating polycrystalline silicon) (11a, 11b) which is covered by a nitride layer (SiₓN_{y}) (17).

5. A bipolar npn- planar transistor as claimed in one of Claims 1 to 4, characterised in that the aforementioned pn-junction (2) represents the collector-base-diode of the transistor.

6. A process for the production of the bipolar npn- planar transistor as claimed in one of the preceding claims, characterised in that the p-zone (5) is produced by ion implantation followed by diffusion.

7. A process as claimed in Claim 7, characterised in that the p-zone (5) is produced by ion implantation of aluminium.

## Revendications

1. Transistor bipolaire npn de type planar comprenant un corps semi-conducteur (1) présentant plusieurs régions de semi-conducteur ayant des types de conductivité différents, lesquelles forment au moins une jonction pn (2) au moyen d'une région de semi-conducteur (3) à conduction n et d'une région de semi-conducteur (4) à conduction p, la région de semi-conducteur (3) à conduction n étant située sous la région de semi-conducteur (4) à conduction p, dont l'étendue est limitée, et entourant celle-ci complètement, caractérisé en ce
- qu'une zone p (5), s'étendant à partir de la surface (6) du corps semi-conducteur (1), est prévue le long de l'interface (7) de la région de semi-conducteur (4) à conduction p, interface qui délimite l'étendue en surface de cette région, la zone p (5) entourant complètement cette région de semi-conducteur (4) de conduction p,
- que cette zone p (5) s'étend plus profondément dans le corps semi-conducteur (1) que la région de semi-conducteur (4) à conduction p,
- que la largeur de cette zone p (5) est faible en comparaison avec l'étendue de la région de semi-conducteur (4) de conduction p,
- que cette zone p (5) est faiblement dopée p et qu'elle est notamment dopée plus faiblement que la région de semi-conducteur (4) à conduction p et
- que cette zone p (5) est entièrement recouverte d'une couche de passivation (8).

2. Transistor bipolaire npn de type planar selon la revendication 1, caractérisé en ce qu'un caisson mésa (18) se raccorde directement à la zone p (5) et l'entoure en forme d'anneau, que ce caisson mésa (18) s'étend plus profondément dans le corps semi-conducteur (1) que la zone p (5) et que la surface du caisson mésa (18) est recouverte par la couche de passivation (8).

3. Transistor bipolaire npn de type planar selon la revendication 1 ou 2, caractérisé en ce que la couche de passivation (8) est en verre.

4. Transistor bipolaire npn de type planar selon la revendication 1 ou 2, caractérisé en ce que la couche isolante (11) est composée d'une ou plusieurs couches SIPOS (silicium polycristallin semi-isolant) (11a, 11b), qui est recouverte d'une couche de nitrure (SiₓN_{y}) (17).

5. Transistor bipolaire npn de type planar selon une des revendications 1 à 4, caractérisé en ce que la jonction pn (2) mentionnée représente la diode collecteur-base du transistor.

6. Procédé pour fabriquer le transistor bipolaire npn de type planar selon une des revendications précédentes, caractérisé en ce que la zone p (5) est produite par implantation ionique suivie d'une diffusion.

7. Procédé selon la revendication 6, caractérisé en ce que la zone p (5) est produite par implantation d'ions d'aluminium.
